Europäisches Patentamt

European Patent Office

Office européen des brevets

(19)

(11) Veröffentlichungsnummer: **0 174 004 B1**

(12) **EUROPÄISCHE PATENTSCHRIFT**

(45) Veröffentlichungstag der Patentschrift: **08.08.90**

(21) Anmeldenummer: **85111101.3**

(22) Anmeldetag: **03.09.85**

(51) Int. Cl.⁵: **C 30 B 15/30, C 30 B 13/32**

(54) **Verfahren zur Herstellung eines kristallinen Körpers aus der Schmelze.**

(30) Priorität: **04.09.84 DE 3432467**
**09.08.85 DE 3530417**

(43) Veröffentlichungstag der Anmeldung:
**12.03.86 Patentblatt 86/11**

(45) Bekanntmachung des Hinweises auf die
Patenterteilung:
**08.08.90 Patentblatt 90/32**

(84) Benannte Vertragsstaaten:
**AT BE CH DE FR GB IT LI LU NL SE**

(56) Entgegenhaltungen:
**DE-A-1 644 020      US-A-4 087 239**
**DE-A-2 306 755**

**IBM TECHNICAL DISCLOSURE BULLETIN, Band
26, Nr. 10B, März 1984, Seiten 5542-5543, New
York, US; K.M. KIM et al.: "Elimination of crystal
orbiting in czochralski cable puller with a
coaxial magnet and magnetic weight"**

**PATENT ABSTRACTS OF JAPAN, Band 8, Nr. 93
(C-220)1530r, 27. April 1984; & JP-A-59 8697
(TOKYO SHIBAURA DENKI K.K.) 17-01-1984**

(73) Patentinhaber: **Forschungszentrum Jülich
GmbH
Postfach 1913
D-5170 Jülich (DE)**

(72) Erfinder: **Boden, Karl
Siemensstrasse 20
D-5170 Jülich (DE)**
Erfinder: **Ibach, Harald, Prof. Dr.
Kalkbergstrasse 167
D-5100 Aachen-Verlautenheide (DE)**
Erfinder: **Linke, Udo
Im Reuter 37
D-5160 Düren (DE)**

EP 0 174 004 B1

Courier Press, Leamington Spa, England.

**Beschreibung**

Die Erfindung bezieht sich auf ein Verfahren zur Herstellung eines kristallinen Körpers aus der Schmelze, bei dem Schmelze (bzw. Tiegel oder Vorratsstab) und kristalliner Körper eine solche Relativbewegung zueinander ausführen, daß bei aus der Schmelze gezogenem kristallinem Körper eine zweidimensionale Durchmischung der Schmelze bewirkt wird.

Ein Verfahren der eingangs bezeichneten Art ist — soweit es das Tiegelschmelzverfahren nach Czochralski betrifft — aus der DE-OS 16 44 020 bekannt. Die zweidimensionale Durchmischung der Schmelze soll dabei dazu dienen, neben einer verbesserten Kristallqualität eine vergleichsweise gleichmäßige radiale Widerstandsverteilung über den gesamten Querschnitt des stabförmigen kristallinen Körpers zu erzielen, wobei die zweidimensionale Durchmischung eine homogenere Verteilung der Dotierungsstoffe auf das Schmelzvolumen bewirken soll.

Die Durchführung des bekannten Verfahrens wird mit üblichen Antriebsmitteln bewerkstelligt, wobei eine hyperzykloide Bahn des Keimlings dadurch eizeugt wird, daß sich sowohl der Tiegel als auch die Halterung des kristallinen Körpers jeweils um ihre eigenen, räumlich nicht zusammenfallenden Achsen drehen und der kristalline Körper exzentrisch an der Halterung befestigt ist. Schon bei diesen einfachen Drehbewegungen von Tiegel und Halterung, die in üblicher Weise mittels elektromotorischen Antrieben und daher über Achsen, Getriebe bzw. Gestänge übertragen werden müssen, kann jedoch nicht verhindert werden, daß von außen kommende Störungen (Schwingungen, Stöße) auf Tiegel und kristallinen Körper übertragen.

Es ist Aufgabe der Erfindung, ein Verfahren zu schaffen, bei dem der kristalline Körper, der Tiegel und/oder — bei Durchführung des tiegellosen Zonenschmelzverfahrens — der Vorratsstab außer in einfache Drehbewegungen oder in eine von der Ausgangslage abweichende Lage auch in vorbestimmte Relativbewegungen zueinander versetzt werden können, ohne daß die vorgenannten Nachteile in Kauf genommen werden müssen. Dabei sollen auch komplexe Bewegungsabläufe nicht nur im Zusammenspiel zwischen Tiegel und kristallinem Körper oder kristallinen Körper und Vorratsstab, sondern auch durch Bewegung des kristallinen Körpers, des Tiegels oder des Vorratsstabes allein möglich sein. Das Verfahren soll sowohl hyperzykloide, epizykloide als auch andere komplexe Bewegungsabläufe ermöglichen.

Die der Erfindung zugrundeliegende Aufgabe wird bei einem Verfahren der eingangs bezeichneten Art dadurch gelöst, daß eine Vorrichtung zum tiegellosen Zonenschmelzen und/oder zum Ziehen aus einem Tiegel mit einer Stab- und Tiegelhalterung verwendet wird, an der ein mittels eines Magneten (Axialstabilisierungsmagnet) aufgehängter magnetisierbarer Kern angebracht ist, wobei an dem Magneten eine Einrichtung zur axialen Verschiebung angreift und bei der wenigstens eine Radialstabilisierungseinrichtung für den magnetisierbaren Kern vorgesehen ist, die aus den magnetisierbaren Kern berührungslos umschließenden Elektromagneten einem elektronischen Regelgerät und Positionssensoren besteht, wobei die Elektromagnete vom elektronischen Regelgerät mit Signalen beaufschlagt werden, die von diesem als Funktion der Signale der Positionssensoren, welche auf die Abweichungen des magnetisierbaren Kerns von seiner Sollage ansprechen, erzeugt werden, und daß zur radialen Verlagerung des magnetisierbaren Kerns und/oder zur Erzeugung von periodischen Schwingungsbewegungen des magnetisierbaren Kerns und/oder von Drehbewegungen desselben statische und/oder sich periodisch ändernde Wechsel- oder Drehströme in die Elektromagnete der Radialstabilisierungseinrichtung eingespeist werden.

Bei der verwendeten Vorrichtung wird durch die berührungslose Fixierung des magnetisierbaren Kerns in der axialen lage - abgesehen von der reibungslosen axialen Verschiebung - erreicht, daß der magnetisierbare Kern und der an der Halterung befestigte kristalline Körper und/oder der Tiegel oder der Vorratsstabteil frei von Erschütterungen und Schwingungen bleibt.

Die Radialstabilisierungseinrichtung bewirkt, daß der magnetisierbare Kern auch bei einer axialen Verschiebung in der radialen Sollage bleibt, er wird somit durch die Magnetkräfte in axialer Richtung geführt. Einer weiteren Führung des magnetisierbaren Kerns, wie dies beispielsweise bei der aus der D-PS 23 06 755 bekannten Vorrichtung durch die Behälterinnenwand im Bereich des ferromagnetischen Kerns geschieht, bedarf es daher bei der verwendeten Vorrichtung nicht, ebensowenig, wie es eines den kristallinen Körper einschließenden Behälters bedarf. Die verwendete Vorrichtung ist daher bei Kristallzuchtapparaturen sowohl mit als auch ohne einen den kristallinen Körper einschließenden Behälter einsetzbar.

Für den Fall, daß ein den sich bildenden kristallinen Körper einschließender Behälter oder eine Kammer (beispielsweise eine hochdichte Druckkammer) vorgesehen ist, muß die Wandung des Behälters oder der Kammer allerdings in dem den magnetisierbaren Kern umfassenden Bereich aus nichtmagnetisierbarem Material bestehen. Gleitende Dichtungen und sonstige Dichtungen im Bereich der Behälterwandung, wie sie insbesondere bei einer mechanischen radialen Führung bzw. einer mechanischen Einrichtung zur axialen Verschiebung der Halterung notwendig wären, entfallen. Die verwendete Vorrichtung eignet sich daher inbesondem Maße für Zuchtprozesse, bei denen die in der Kammer befindliche Atmosphäre höchsten Reinheitsansprüchen genügen muß.

Bei der Durchführung des Verfahrens gemäß der Erfindung werden durch gezielte Überlagerung von elektromagnetisch erzeugten statischen und dynamischen Feldern die zusätzlichen Bewegungen des magnetisierbaren Kerns erzeugt.

Asymmetrische Änderungen der radialen Felder bewirken dabei radiale Körperverlagerungen, periodisch einseitige Feldänderungen erzeugen oszillierende Bewegungen, periodisch asymmetrische Drehfelder verursachen Rotation der Körperachse. Durch Überlagerung dieser Verschiebungen und Bewegungen mit der Rotation des Körpers um seine Achse können sehr komplexe Bewegungsvorgänge in der Schmelzzone erzeugt werden, so auch epi- oder hypozyklische Bewegungen. Auch ist es möglich, axiale Oszillationsbewegungen des magnetisierbaren Kerns zu erhalten.

Selbstverständlich kann eine radiale Verschiebung der Achse des kristallinen Körpers (bzw. des magnetisierbaren Kerns und der entsprechenden Halterung) auch dadurch erreicht werden, daß die außen liegenden elektromagnetischen Elemente der Radialstabilisierungseinrichtung mechanisch radial verlagert werden.

Die radiale Verlagerung des magnetisierbaren Kerns bei der Durchführung des Verfahrens gemäß der Erfindung erfolgt unabhängig davon, ob der magnetisierbare Kern den kristallinen Körper, den Tiegel oder den Vorratsstab hält.

Die in die Elektromagnete einzuspeisenden Wechseloder Drehströme können beispielsweise direkt als elektrische Störgrößen den Signalen, mit welchen die Elektromagnete vom elektronischen Regelgerät beaufschlagt werden, überlagert werden. Diese gestörten Signale führen über die Elektromagnete zu einer Abweichung des magnetisierbaren Kerns von der Sollage.

Zwar wird das Regelgerät versuchen, den magnetisierbaren Kern wieder in die Sollage zu bringen. Jedoch wird bei bleibender Störung, d.h. bei weiterhin in die Elektromagnete eingespeisten Störsignalen und bei geeignetem Regler, z.B. bei PD-Regler, eine bleibende Abweichung von der Sollage resultieren. Bei geeigneter Wahl der Störsignale entspricht dann die bleibende Abweichung dem gewünschten Bewegungsablauf des magnetisierbaren Kerns.

Als vorteilhaft hat sich eine Ausführungsvariante des Verfahrens gemäß der Erfindung erwiesen, die darin besteht, daß zur Erzeugung des vorbestimmten Bewegungsablaufs des magnetisierbaren Kerns die statischen und/oder sich periodisch verändernden Wechseloder Drehströme dadurch erzeugt werden, daß Führungssignale in das oder die Regelgeräte eingegeben werden, die der gewünschten statischen oder zeitlich veränderten Sollage (bzw. dem gewünschten Bewegungsablauf) des magnetisierbaren Kerns entsprechen. Damit wird dem Regelgerät, das die Aufgabe hat, den magnetisierbaren Kern in seine Sollage einzuregeln, eine dem gewünschten Bewegungsablauf entsprechende zeitliche Sollage vorgegeben. Das Regelgerät wird — je nach Art der zeitlichen Veränderung der vorgegebenen Sollage und nach Art des Reglers — den magnetisierbaren Kern direkt oder mit zeitlicher Verzögerung in die gewünschte Sollage bringen, wodurch der gewünschte Bewegungsablauf entsteht. Dabei kann die nunmehr vorgegebene Sollage von der ursprünglichen Sollage statisch abweichen, einer Sprungfunktion oder einer Sinusfunktion oder auch einer sonstwie gearteten Funktion folgen. Sind dabei sowohl der kristalline Körper als auch der Tiegel oder der kristalline und der Vorratsstab magnetisch radial stabilisiert, so können durch Überlagerung von Bewegungen dieser Elemente beliebige komplexe Bewegungen - schon bei einfachen Radialstabilisierungseinrichtungen — erzeugt werden.

Eine solche Stabilisierungseinrichtung besteht in der Regel aus zwei Sensoren- und Elektromagnetenpaaren, wovon zwei Sensoren mit je einem Regelgerät gekoppelt sind. Die jeweils einander zugeordneten Sensoren liegen auf entgegengesetzten Seiten des magnetisierbaren Kerns einander gegenüber. Die Verbindungslinien der einander jeweils zugeordneten Sensoren stehen senkrecht aufeinander.

Bei einer zweckmäßigen Ausführungsart des Verfahrens gemäß der Erfindung werden den Regelgeräten Führungssignale gleicher Frequenz eingegeben, die sich von Regelgerät zu Regelgerät in ihrer Amplitude und/oder in ihrer Phase unterscheiden.

Dadurch werden Bewegungen des magnetisierbaren Kerns erzeugt, bei der der Achsenpunkt des Kerns in der Ebene der Radialstabilisierungseinrichtung eine Elipse mit feststehenden Achsen beschreibt. Wie leicht einzusehen ist, können auf diese Weise auch rein kreisförmige Bewegungen (Phasenwinkel 90°, gleiche Amplituden) oder rein translatorische Bewegungen (z.B. Phasenwinkel 0°) erzeugt werden.

Es kann ferner zweckmäßig sein, den Regelgeräten zeitlich sich ändernde Führungssignale einzugeben. Werden beispielsweise die Frequenz nur eines der Führungssignale (bei gleichbleibenden Amplituden der Führungssignale) verändert, so werden Bewegungen erzeugt, bei denen der Achsen punkt des magnetisierbaren Kerns in der Ebene einer einfachen Radialstabilisierungseinrichtung die bekannten Lissajou-Figuren für Schwebungen beschribt. Durch Eingabe von Führungssignalen, bei denen auch die weiteren Bewegungsparameter verändert werden, können ohne weiteres komplexe Bewegungen erzeugt werden.

Bei in übereinanderliegenden Ebenen angeordneten Radialstabilisierungseinrichtungen ergeben sich weitere Möglichkeiten für komplexe Bewegungen des magnetisierbaren Kerns: Werden die Regelgeräte der beiden Radialstabilisierungseinrichtungen mit den gleichen Führungssignalen beaufschlagt, dann führt der magnetisierbare Kern Bewegungen aus, ohne dabei von seiner vertikalen Lage abzuweichen. Werden die Regelgeräte dagegen mit unterschiedlichen Führungssignalen beaufschlagt, so führt der magnetisierbare Kern Taumelbewegungen aus, was zu komplexen Dewegungen des am magnetisierbaren Kern hängenden Elementes (kristalliner Körper, Tiegel, Vorratsstab) führt.

Das Verfahren gemäß der Erfindung bietet somit die Möglichkeit, eine Vielzahl von Bewegungsabläufen des kristallinen Körpers, des Tiegels oder des Vorratsstabs störungsfrei und reproduzierbar einzustellen. Bei Verwendung einer Kraftmeßeinrichtung, die direkt unterhalb des Axialstabilisierungsmagneten oder des Linearmotors, aber auch unterhalb des gesamten, beispielsweise den Linearmotor und die Elektromagnete der Radialstabilisierungseinrichtung umfassenden hohlzylindrischen Stators angeordnet sein kann, bietet sich außerdem die Möglichkeit, die Gewichtszunahme des wachsenden kristallinen Körpers genau zu verfolgen und für eine Kontrolle des Kristallwachstums nutzbar zu machen. Vor allem dann, wenn eine den kristallinen Körper umgebende Zuchtkammer vogesehen ist, können praktisch alle bekannten, den Zuchtprozeß beeinflussenden Parameter gleichzeitig eingestellt und unabhängig voneinander variiert werden. Das Verfahren gemäß der Erfindung eignet sich in Verbindung mit der zu verwendenden Vorrichtung nicht nur zur Optimierung der Kristallzuchtvorgänge, sondern es kann eingesetzt werden bei der Erforschung von Kristallzuchtvorgängen selbst und zur Zucht neuer Kristallgruppen auch unter Kombination von Kristallzucht und Kristalldostierung.

Bei der Durchführung des Verfahrens gemaß der Erfindung wird zweckmäßigerweise eine Ausführungsform der Vorrichtung verwendet, bei der die Radialstabilisierungseinrichtung ringförmig ausgebildet ist und den magnetisierbaren Kern, zwischen diesem und sich einen Ringspalt bildend, umschließt. Dabei kann auch zweckmäßig sein, daß die Elektromagnete der Radialstabilisierungseinrichtung mit einer im Ringspalt im wesentlichen radial gerichteten Vormagnetisierung versehen sind. Zur Vormagnetisierung können dabei Permanentmagnete vorgesehen sein.

Bei dieser Ausführungsform der Vorrichtung ist ohne weiteres ein Ringspalt mit einer Spaltbreite von mehr als 13 mm realisierbar. Dieser Ringspalt bietet genügend Raum für eine Bewegung des magnetisierbaren Kerns.

Zur axialen Verschiebung des magnetisierbaren Kerns kann der Axialstabilisierungsmagnet so angeordnet sein, daß er sich unmittelbar oberhalb der Elektromagnete der Stabilisierungseinrichtung befindet, so daß sein Magnetfeld den Ringspalt zwischen Elektromagneten und magnetisierbarem Kern im wesentlichen radial durchsetzt und die Vormagnetisierung bewirkt.

Die zur Verschiebung in axialer Richtung erforderliche Bewegung des Axialstabilisierungsmagneten kann dadurch erzeugt werden, daß der Axialstabilisierungsmagnet an einem Befestigungsrahmen — der Einrichtung zur Aufhängung der Halterung und deren axialen Verschiebung angebracht ist, der separat in axialer Richtung verschiebbar ist. Bei einer besonders eleganten Ausführungsform der verwendeten Vorrichtung besteht die Einrichtung zur axialen Verschiebung des magnetisierbaren Kerns dagegen aus einem elektromagnetischen Linearmotor, der aus einem hohlzylindrischen Stator und dem magnetisierbaren Kern als Antriebselement besteht. Die axiale Verschiebung erfolgt dabei allein über magnetische Feldkräfte. Mechanisch bewegbare Teile sind dabei nicht vorgesehen.

Eine weitere, für die Durchführung des Verfahrens gemäß der Erfindung zweckmäßige Ausführungsform der verwendeten Vorrichtung besteht ferner darin, daß ein ringförmiger Drehfeldstator mit einem zwischen sich und dem magnetisierbaren Kern gebildeten Ringspalt vorgesehen ist. Der axialen Verschiebung des magnetisierbaren Kerns kann so mittels des Drehfeldstators eine Drehbewegung überlagert werden, falls diese aus qualitativen Gründen bei der Herstellung des kristallinen Körpers erwünscht ist.

In der Zeichnung sind Ausführungsbeispiele der bei der Durchführung des Verfahrens gemäß der Erfindung verwendeten Vorrichtung dargestellt. Sie werden im folgenden näher erläutert. Dabei wird auch das Verfahren gemäß der Erfindung anhand eines der Ausführungsbeispiele der Vorrichtung näher beschrieben.

Es zeigen:

Figur 1 eine einfache Ausführungsform einer Vorrichtung zur Durchführung des Tiegelschmelzverfahrens mit magnetisch aufgehängtem und in axialer Richtung verschiebbarem Kristall.

Figur 1a die Ausführungsform der Vorrichtung gemäß Figur 1 mit zusätzlichen Bauelementen zur Durchführung des Verfahrens,

Figur 1b ein teilweiser Querschnitt längs der linie A/A, der in Figur a dargestellten Vorrichtung,

Figur 2 eine einfache Ausführungsform einer Vorrichtung zur Durchführung des Tiegelschmelzverfahrens mit magnetisch aufgehängtem und in axialer Richtung verschiebbarem Schmelztiegel,

Figur 3 eine Ausführungsform einer Vorrichtuno zur Durchführung des Tiegelschmelz verfahrens mit Zuchtkammer, Linearmotor zur axialen Fixierung und Verschiebung der Halterung des Kristalls sowie mit einer Kraftmeßeinrichtung zur Messung der Gewichtsänderung des Kristalls,

Figur 4 eine weitere Ausführungsform der Vorrichtung,

Figur 5 eine Ausführungsform einer Vorrichtung zur Durchführung des Zonenschmelzverfahrens.

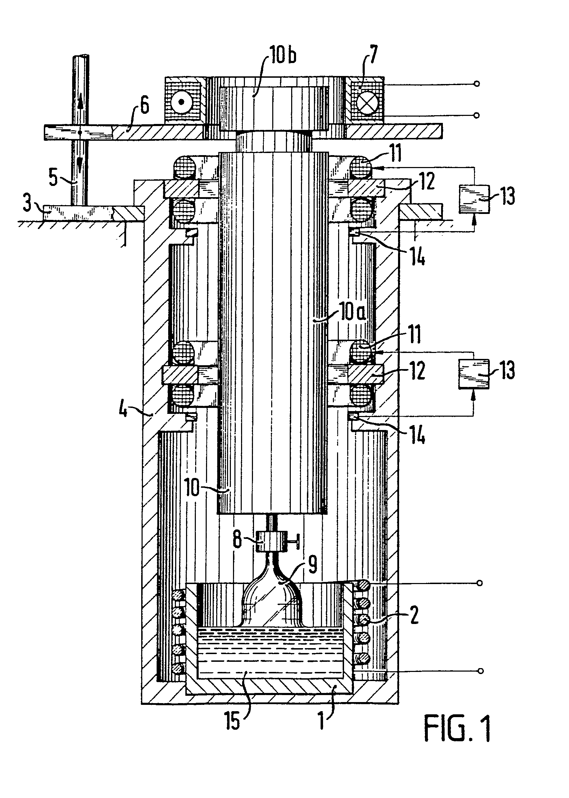

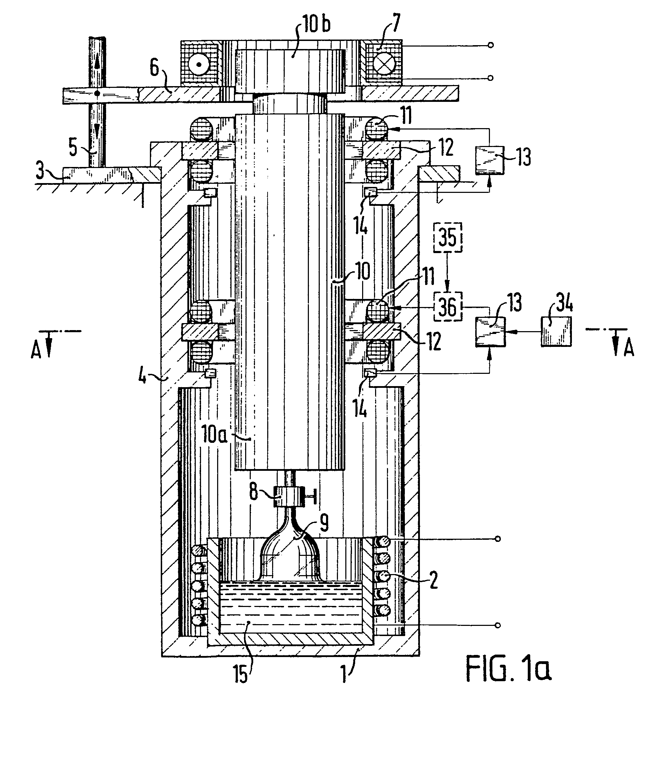

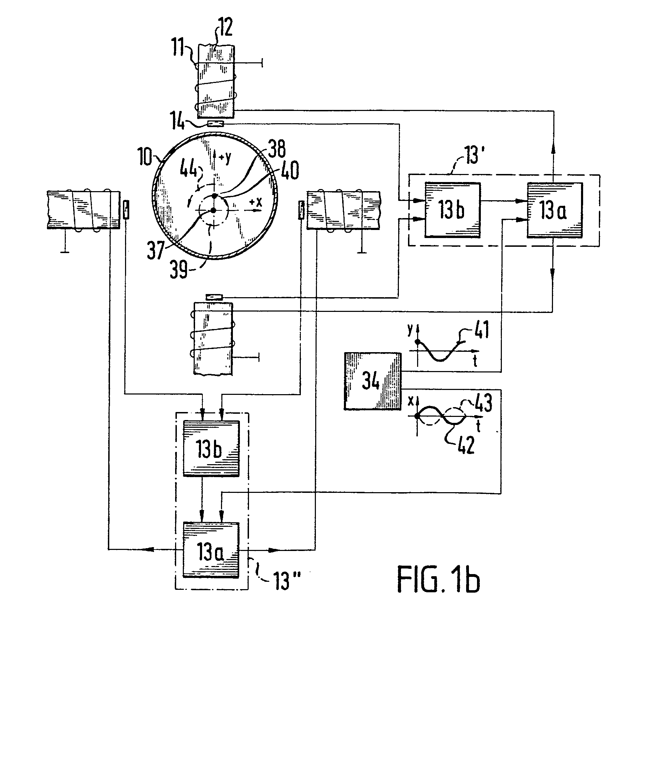

Die in Figur 1 dargestellte Vorrichtung weist einen Schmelztiegel 1 mit einer Widerstandsheizung 2 für den Schmelztiegel auf. Der Schmelztiegel steht auf dem mit der festen Unterlage 3 verbundenen Befestigungsrahmen 4 für die Radialstabilisierungseinrichtungen. Auch der Befestigungsrahmen 5 mit der in der Höhe verstellbaren Halteplatte 6 für den Elektromagneten 7 ist an der festen Unterlage 3 angebracht. Die Vorrichtung weist ferner eine Befestigung 8 für den Kristall 9 auf, an der der magnetisierbare Kern 10 befestigt ist. Dieser besteht in seinem unteren Teil aus einem langgestreckten Hohlzylinder 10a aus nichtrostendem, magnetisierbarem Stahl und einem darüber angeordneten zylindrischen Permanentmagneten 10b. Der Elektromagnet 7 ist in einer solchen Höhe angeordnet, daß er den Permanentmagneten 10b des magnetisierbaren Kerns in Arbeitsstellung umfaßt, so daß dieser — bei angeschaltetem Elektromagnet — in axialer Richtung fixiert wird. Die Höhenverschiebung der Halteplatte 6 kann mittels eines in der Zeichnung nicht dargestellten Spindelantriebs oder eines hydraulischen Zylinders erfolgen. Die zwei am Gestellrahmen 4 befestigten Radialstabilisierungseinrichtungen bestehen aus je vier Spulen 11 mit ferromagnetischem Kern 12, die jeweils paarweise einander gegenüberliegen und von denen nur die beiden in der Zeichnungsebene liegenden dargestellt sind und die jeweils paarweise mit elektronischen Regelgeräten 13 in elektrischer Verbindung stehen und von diesen mit einem Gleichstrom beaufschlagt werden, dessen Höhe von den Meßsignalen abhängig ist, die von induktiven Sensoren 14 ausgehen und den Regelgeräten 13 zugeleitet werden. Dabei werden die von den induktiven Sensoren an die Regelgeräte 13 geleiteten Meßsignale verstärkt und in ihrer Phase verschoben als Ausgangssignale in Form eines geregelten Gleichstromes an die Spulen 11 abgegeben.

Bei der Herstellung des Kristalls 9 wird dieser aus der Schmelze 15 gezogen. Hierzu wird der eingeschaltete Elektromagnet 7, an dem der magnetisierbare Kern 10 mit Befestigung 8 und dem daran befestigten Kristall 9 aufgehängt ist. in axialer Richtung verschoben.

Figur 1a zeigt die Ausführungsform der Vorrichtung gemäß Figur 1 mit zusätzlichen Bauelementen in der unteren, in der Höhe der Linie A/A befindlichen Radialstabilisierungseinrichtung. Diese zusätzlichen Bauelemente dienen der Durchführung zweier unterschiedlicher Ausführungsvarianten des Verfahrens gemäß der Erfindung. Bei der Verfahrensvariante 1 werden die in die Elektromagnete einzuspeisenden Wechsel- oder Drehströme direkt als elektrische Störgrößen den Signalen mit welchen die Elektromagnete 11 vom elektronischen Regelgerät 13 beaufschlagt werden, überlagert. Zur Durchführung dieser Verfahrensvariante 1 werden der Generator 35 und die Trenneinrichtung 36 (die in unterbrochenen Linien dargestellt sind) benötigt. Bei der Verfahrensvariante 2 werden die statischen und/oder sich periodisch ändernden Wechsel- oder Drehströme dadurch erzeugt, daß Führungssignale in das oder die Regelgeräte 13 eingegeben werden, die der gewünschten statischen oder zeitlich veränderten Sollage (bzw. dem gewünschten Bewegungsablauf) des magnetisierbaren Kerns 10 entsprechen. Hierzu wird beispielsweise der in Figur la dargestellte Generator 34 benötigt. Das Bauelement 34 und die Bauelemente 35 und 36 werden somit für unterschiedliche Verfahrensweisen eingesetzt Sie sind lediglich als mögliche Alternativen in der Figur la gemeinsam dargestellt.

Bei der genannten Verfahrensvariante 1 werden vom Generator 35 kommende Störsignale über die Trenneinrichtung 36 zu dem Elektromagneten 11 geleitet, was zu einer Abweichung des magnetisierbaren Kerns 10 von seiner Sollage führt. Zwar meldet daraufhin der Sensor 14 die Abweichung des Kerns von der Sollage, und der Regler 13 versucht den magnetisierbaren Kern wieder auf die Sollage zurückzuführen. Bei bleibendem, über die Trenneinrichtung 36 gegebenem Störsignal resultiert jedoch z.B. bei Verwendung eines PD-Reglers eine bleibende Abweichung, die bei geeignetem Störsignal dem gewünschten Bewegungsablauf des magnetisierbaren Kerns 10 entspricht. Ein weiteres Störsignal kann selbstverständlich auf die gleiche Weise in einen der oder in die in der Zeichnungsebene nicht darstellbaren weiteren Elektromagnete dieser unteren Radialstabilisierungseinrichtung eingegeben werden.

Die Verfahrensvariante 2 wird im folgenden anhand der Darstellung in Figur 1b erläutert: Vom Sinus-Kosinus-Generator 34 werden den Reglern 13a der beiden Regelgeräte 13' und 13'' Sinus- bzw. Kosinusschwingungen als veränderliche Sollwerte eingegeben, wobei als Sollwert die Abweichung vom ursprünglichen Sollwert, d.h. der Lage des magnetisierbaren Kerns 10 ohne Radialverlagerung verstanden wird. Hierzu wird dem Regelgerät 13' das Führungssignal 41 für die Lage des magnetisierbaren Kerns 10 in der Y-Richtung und dem Regelgerät 13'' das Führungssignal 42 für die Lage des Kerns in X-Richtung eingegeben. Bei den aus der Zeichnung ersichtlichen Anfangswerten der Führungssignale ergibt sich dabei die dargestellte Lage des magnetisierbaren Kerns in der Schnittebene A/A, bei der sein Achsenpunkt 38 um +Y von dem Punkt 37 der zentralen Achse der Vorrichtung abweicht. Die Abweichung in X-Richtung ist in diesem Moment gleich Null. Im weiteren Verlauf der Führungssignale 41 und 42 beschreibt der Punkt 38 der Achse des Kerns die Kreisbahn 39 um den Achsenpunkt 37 der Vorrichtung mit der Bewegungsrichtung 40.

Bleibt die Eingabe eines veränderlichen Sollwertes auf die untere Radialstabilisierungseinrichtung beschränkt, dann beschreibt der magnetisierbare Kern beim angegebenen Beispiel eine kreisförmige Pendelbewegung, wobei der ruhende Punkt der Achse des magnetisierbaren Kerns im Bereich der oberen Radialstabilisierungseinrichtung (s. Figur 1a) liegt.

Wird dem Regler 13' anstelle des Führungssignals 42 das Führungssignal 43 eingegeben, dann beschreibt der magnetisierbare Kern 10 eine kreisförmige Pendelbewegung mit der umgekehrten Bewegungsrichtung 44.

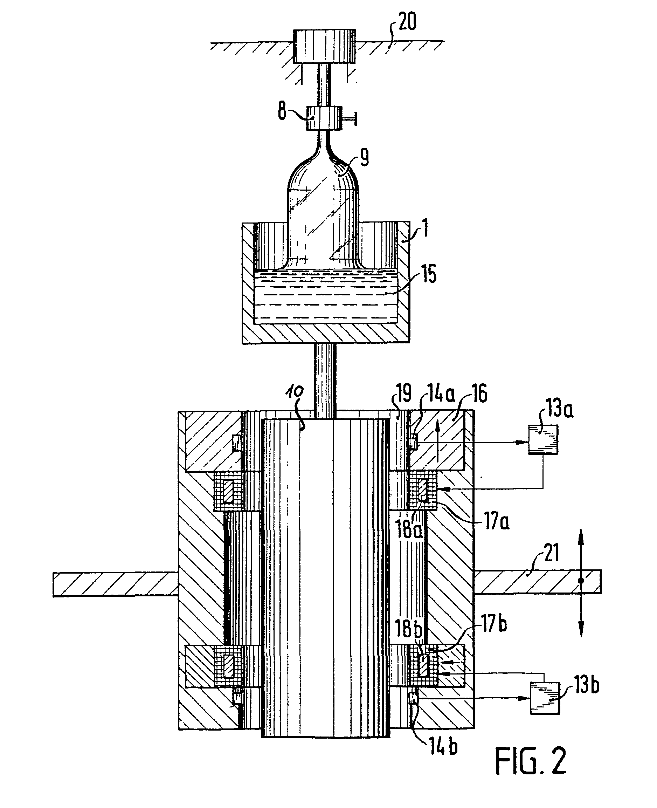

Eine radiale Verlagerung des magnetisierbaren Kerns kann selbstverständlich auch im Bereich der oberen Radialstabilisierungseinrichtung vorgenommen werden. Außerdem kann auch der Tiegel (wie in Figur 2 dargestellt) magnetisch aufgehängt sein und einem vorgegebenen Bewegungsablauf unterworfen werden. Werden derartige Bewegungsabläufe einander überlagert, so können, zumal auch andere von der Sinusfunktion abweichende Führungssignale eingegeben werden können, beliebige komplexe Relativbewegungen zwischen kristallinem Körper und der Schmelze erzeugt werden.

Bei der in Figur 2 dargestellten Vorrichtung ist anders — als bei der in Figur 1 dargestellten Vorrichtung — nicht der Kristall, sondern der Tiegel magnetisch aufgehängt. Hierzu ist unterhalb des Tiegels 1 der magnetisierbare Kern 10 angebracht, der in Arbeitsstellung an seinem oberen Ende von einem ringförmigen, als Axialstabilisierungsmagnet wirkenden Permanentmagneten 16 umfaßt wird. Unterhalb des Permanentmagneten befindet sich Ringspule 17a mit ferromagnetischem Kern 18a, die mit dem Regelgerät 13a und Feldplatten 14a in elektrischer Verbindung stehen. Der Permanentmagnet bewirkt eine radial gerichtete Vormagnetisierung im Ringspalt 19. Eine weitere Radialabilisierungseinrichtung, bestehend aus Ringspule 17b, Kern 18b, Feldplatten 14b und Regelgerät 13b, befindet sich am unteren Ende des magnetisierbaren Kerns 10.

Die Ringspulen entsprechen im übrigen den in der DE—S 24 20 814 gemachten Angaben.

Bei der in Figur 2 dargestellten Ausführungsform ist der Kristall über die Befestigung 8 unbeweglich an einem festen Rahmen 20 befestigt. Permanentmagnet 16 und die Ringspulen 17 sind an einem gemeinsamen, in der Höhe verstellbaren Gestellrahmen 21 befestigt. Der Tiegel 1 kann so bei der Herstellung des Kristalls in axialer Richtung verschoben werden.

Die Heizeinrichtung für den Tiegel ist in Figur 2 und den folgenden Figuren nicht dargestellt. Sie kann eine Widerstandsheizung oder beispielsweise auch eine HF-Spule sein.

Selbstverständlich können je nach Ausführungsform der Halterung sowohl Tiegel als auch Kristall magnetisch aufgehängt sein.

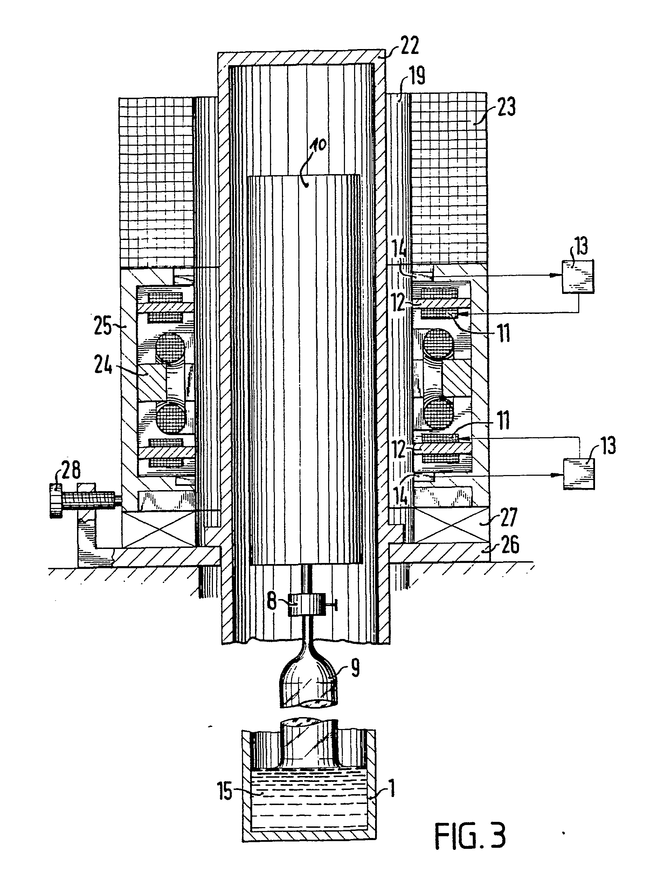

Bei der in Figur 3 dargestellten Vorrichtung ist ein nach außen abgekapselter Zuchtraum vorgesehen der durch den Behälter 22 gebildet wird. Dieser umschließt den magnetisierbaren Kern 10, der, um eine hohe Betriebstemperatur zu ermöglichen, aus einer Stahllegierung mit hoher Curietemperatur besteht, wogegen sich die ringförmig ausgebildeten elektromagnetischen Elemente der Radialstabilisierungseinrichtung außerhalb des Behälters befinden. Die Behälterwandung befindet sich im Bereich der Magnete im Ringspalt 19. Sie besteht zumindest in diesem Bereich aus nichtmagnetisierbarem Material, beispielsweise aus Quarzglas oder aus einer nichtmagnetisierbaren Stahllegierung.

Der ringförmig ausgebildete Linearmotor 23 umschließt den magnetisierbaren Kern 10 in Arbeitsstellung an dessen oberem Ende. ist mit den beiden Radialstabilisierungseinrichtungen, bestehend aus Spulen 11, ferromagnetischem Kern 12, Regelgerät 13 und induktiven Sensoren 14 und einem Drehfeldstator 24 mechanisch fest mit dem Lagerstator 25 verbunden. Am unteren Ende des Lagerstators 25 ist, direkt auf der Unterlage 26 aufliegend, eine Kraftmeßeinrichtung 27 angeordnet.

Der Linearmotor 23 dient der axialen, Fixierung des magnetisierbaren Kerns 10 und zugleich zu dessen axialen Verschiebung, so daß die axiale Verschiebung allein über magnetische Kräfte erfolgt und mechanische Mittel, wie Spindel u.dgl., entfallen.

Der Linearmotor kann aus einem einfachen Tauchspulensystem bestehen, wobei die stabile axiale Höhenlage des magnetisierbaren Kerns 10 eine Funktion des Spulenstromes ist. Die Länge des magnetisierbaren Kerns 10 ist um die Hublänge über die axialen Statorabmessungen hinaus verlängert, so daß alle Arbeitsfunktionen über den gesamten Hubbereich gewährleistet sind.

Der Drehfeldstator 24 übt auf den magnetisierbaren Kern 10 ein Drehmoment aus, welches den Kern und damit den Kristall in Rotation um seine vertikale Achse versetzt. Die benötigte Antriebsleistung ist sehr gering, da Lager und Dichtreibung entfallen. Durch geeignete Materialauswahl und Formgebung des magnetisierbaren Kerns im Antriebsbereich können sowohl Synchronmotoren, wie z.B. Reluktanz- und Hysteresemotoren als auch Asynchronmotoren, wie Induktionsmotoren, in bekannter Weise angewendet werden. Hysteresemotoren erfordern lediglich zylindrische, ringförmige Rotorelemente aus magnetisierbarem Stahl. Aufgrund der geringen Antriebsleistung werden an die Hystereseeigenschaften dieser Stähle keine hohen Anforderungen gestellt, so daß sie aus dem Material des Kerns hergestellt werden können.

Der magnetisierbare Kern kann folglich als durchgehender Stahlzylinder gestaltet werden, der sowohl Lagerals Antriebsanforderungen genügt.

Auf der Kraftmeßeinrichtung 27 ruht das Gewicht des außerhalb der Schmelzkammer angeordneten Stators mit den daran befestigten Lager- und Antriebselementen sowie das Gewicht des magnetisch an den Stator gekoppelten Ziehgestänges, bestehend aus magnetisierbarem Kern 10, Befestigung 8 und dem Kristall 9. Eine Änderung des Kristallgewichts wirkt sich ohne den Einfluß störender Reibungskräfte als Änderung der auf die Kraftmeßeinrichtung einwirkenden Stützkraft aus. In einer bevorzugten Ausführung besteht diese Einrichtung aus drei an den Spitzen eines gleichseitigen Dreiecks angeordneten Kraftmeßzellen. Durch gleichzeitige Addition der drei den Stützkraftanteilen proportionalen elektrischen Ausgangssignalen werden unsymmetrische und periodische, z.B. aus Taumelbewegungen und Unwuchten resultierende Störsignale eliminiert. Da alle anderen durch den Ziehprozeß bedingten thermischen, korrosiven und kammerdruckabhängigen Beeinflussungen der Meßergebnisse entfallen, mißt die Kraftmeßeinrichtung die zeitliche Änderung des Kristallgewichtes mit höchster Genauigkeit und Stabilität.

Unter Verwendung der Kraftmeßeinrichtung kann das Summensignal in einem in der Zeichnung nicht dargestellten Durchmesserregelkreis in einem elektrischen Komparator mit einem den gewünschten Durchmesserverlauf beschreibenden Sollwert verglichen und das Differenzsignal einem Regler zugeführt werden, der in bekannter Weise die Heizleistung oder die Transportgeschwindigkeit des Ziehgestänges in geeigneter Weise nachstellt.

Für den Fall, daß mitkorrodierenden Stoffen in der Schmelzkammer gearbeitet werden muß, kann der magnetisierbare Kern mit einem korrosionsresistenten Überzug aus Quarzglas oder Graphit versehen sein.

Mittels der Stellschraube 28 kann der Stator 25 gegenüber der Unterlage 26 und dem Behälter 22 in radialer Richtung verschoben werden. Diese Justiereinrichtung ermöglicht sowohl die Ausrichtung von Tiegel- und Kristallachse als auch die Festlegung einer für den Zuchtprozeß erwünschten Exzentrizität zwischen den beiden Achsen.

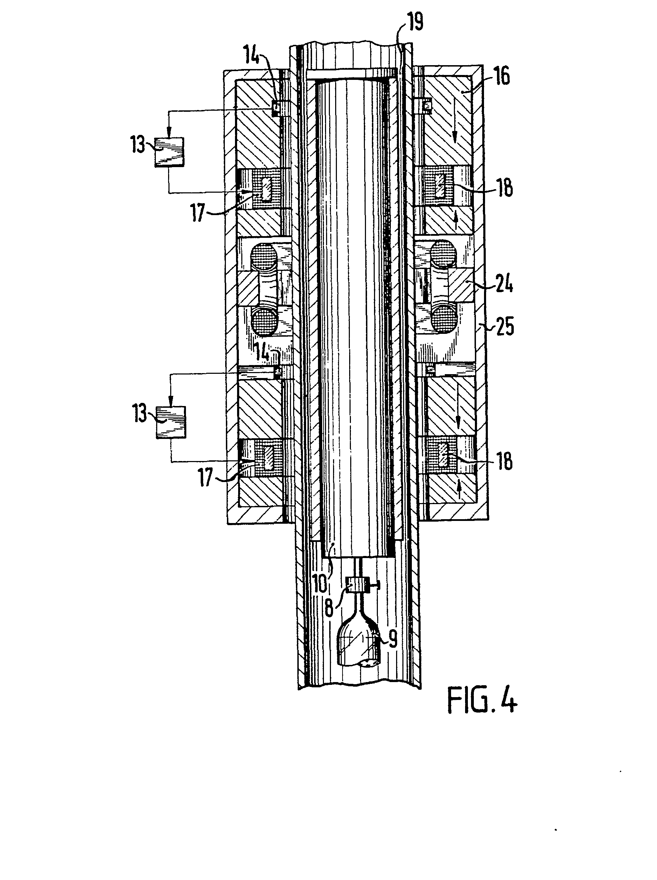

Bei der in Figur 4 gezeigten Ausführungsform der Vorrichtung sind — ebenso wie bei der in Figur 2 gezeigten Ausführungsform — die Elektromagnete der Radialstabilisierungseinrichtung mit einer im Ringspalt 19 im wesentlichen radial gerichteten Vormagnetisierung versehen. Hierzu sind die Ringspulen 17 der oberen Radialstabilisierungseinrichtung unterhalb des als Axialstabilisierungsmagnet wirkenden Permanentmagneten 16 angeordnet. Eine solche externe Vormagnetisierung könnte zwar auch elektromagnetisch erfolgen. Jedoch bietet die Verwendung des Permanentmagneten 16 besondere Vorteile. Denn dieser benötigt keine Leistung, arbeitet störungsfrei und erzeugt durch seine ringförmige Gestalt eine definierte stabile zentrische Achsenlage, bei der die auf den magnetisierbaren Kern einwirkenden stationären, radialen Magnetkräfte gleich Null sind.

Da die auf den magnetisierbaren Kern ausgeübten magnetischen Feldkräfte mit dem Produkt aus Vormagnetisierungs- und Regelfeldstärke anwachsen, können durch hohe permanente Vormagnetisierungsfeldstärke große dynamische Stabilisierungskräfte über große Ringspalte (< 13 mm) bei kleiner elektromagnetisch erzeugter Regelfeldstärke erzeugt werden.

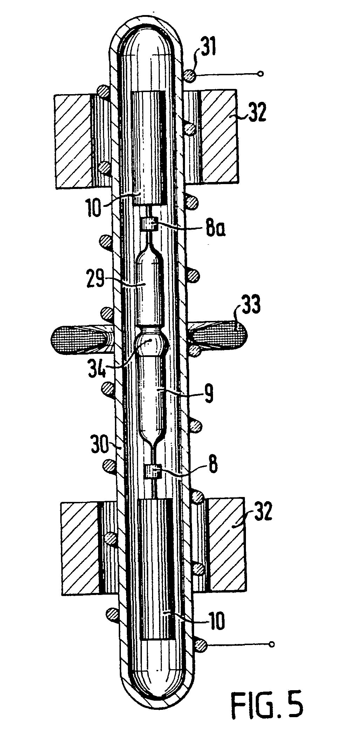

Figur 5 zeigt die Ausführungsform einer Vorrichtung zur Durchführung des Zonenschmelzverfahrens. Bei dieser Ausführungsform sind sowohl an der Befestigung 8 für den kristallinen Stab 9 als auch an der Befestigung 8a für den Vorratsstab 29 je ein magnetisierbarer Kern 10 angebracht. Die Zuchtkammer, in der sich die vorgenannten Vorrichtungteile befinden, ist eine allseits geschlossene zylindrische Ampulle, deren Wandung 30 beispielsweise aus Quarzglas besteht. Diese Zuchtkammer wird durch eine den zylindrischen Teil umschließende Heizwicklung 31 temperiert.

Zur Aufhängung und radialen Verschiebung der magnetischen Kerne 10 sind Einrichtungen 32 vorgesehen, die im Detail den in den bisherigen Figuren dargestellten Ausführungsformen entsprechen können. Diese Einrichtungen sind durch in der Zeichnung nicht wiedergegebene Mittel gegen die Wärmestrahlung abgeschirmt und gekühlt.

Bei der Herstellung des Kristalls wird bei dem in Figur 5 dargestellten Beispiel der Vorratsstab 29 von oben nach unten durch die aus einer Widerstandsheizwicklung 33 bestehende Schmelzspule geführt. Alternativ kann auch die Schmelzspule selbst bewegt werden. Durch unterschiedliche Vorschubgeschwindigkeiten der beiden Stabteile 9 und 29 kann eine Streckung oder Stauchung in der Schmelzzone 34 bewirkt werden. Ein gewünschter seitlicher Versatz der Drehachse kann durch eine entsprechende mechanische Justierung der Lagerstatoren realisiert werden. Mittels Drehfeldstatoren ist es möglich, die magnetisierbaren Kerne 10 in Rotation zu versetzen.

**Patentansprüche**

1. Verfahren zur Herstellung eines kristallinen Körpers aus der Schmelze, bei dem Schmelze (bzw. Tiegel oder Vorratsstab) und kristalliner Körper eine solche Relativbewegung zueinander ausführen, daß bei aus der Schmelze gezogenem kristallinem Körper eine zweidimensionale Durchmischung der Schmelze bewirkt wird, dadurch gekennzeichnet, daß eine Vorrichtung zum tiegellosen Zonenschmelzen und/oder zum Ziehen aus einem Tiegel mit einer Stabund Tiegelhalterung verwendet wird, an der ein mittels eines Magneten (Axialstabilisierungsmagnet) aufgehängter magnetisierbarer Kern angebracht ist, wobei an dem Magneten eine Einrichtung zur axialen Verschiebung angreift und bei der wenigstens eine Radialstabilisierungseinrichtung für den magnetisierbaren Kern (10) vorgesehen ist, die aus den magnetisierbaren Kern berührungslos umschließenden Elektromagneten (11) einem elektronischen Regelgerät (13) und Positionssensoren (14) besteht, wobei die Elektromagnete vomelektronischen Regelgerät mit Signalen beaufschlagt werden, die von diesem als Funktion der Signale der Positionssensoren, welche auf die Abweichungen des magnetisierbaren Kerns von seiner Sollage ansprechen, erzeugt werden, und daß zur radialen Verlagerung des magnetisierbaren Kerns und/oder zur Erzeugung von periodischen Schwingungsbewegungen des magnetisierbaren Kerns und/oder von Drehbewegungen desselben statische und/oder sich periodisch ändernde Wechseloder Drehströme in die Elektromagnete der Radialstabilisierungseinrichtung eingespeist werden.

2. Verfahren nach Anspruch 1, dadurch gekennzeichnet, daß zur Erzeugung des vorbestimmten Bewegungsablaufs des magnetisierbaren Kerns die statischen und/oder sich periodisch verändernden Wechseloder Drehströme dadurch erzeugt werden, daß Führungssignale in das oder die Regelgeräte (13) eingegeben werden die der gewünschten statischen oder zeitlich veränderten Sollage (bzw. dem gewünschten Bewegungsablauf) des magnetisierbaren Kerns (10) entsprechen.

3. Verfahren nach Anspruch 2, dadurch gekennzeichnet, daß den Regelgeräten (13) Führungssignale gleicher Frequenz eingegeben werden, die sich von Regelgerät zu Regelgerät in ihrer Amplitude und/oder Phase unterscheiden.

4. Verfahren nach Anspruch 2, dadurch gekennzeichnet, daß den Regelgeräten (13) zeitlich sich ändernde Führungssignale eingegeben werden.

## Revendications

1. Procédé de fabrication d'un corps cristallin à partir d'un bain fondu, dans lequel le bain fondu (et le creuset ou la tige de réserve) et le corps cristallin effectuent un mouvement relatif tel qu'il provoque, dans le cas d'un corps cristallin tiré du bain, un mélange suivant deux dimensions du bain, caractérisé en ce qu'il consiste à utiliser une installation de fusion de zone sans creuset et/ou de tirage à partir d'un creuset avec un dispositif de support d'une tige et d'un creuset sur lequel est monté un noyau magnétisable suspendu au moyen d'un aimant (aimant de stabilisation axiale), un dispositif de déplacement axial attaquant l'aimant et il est prévu au moins un dispositif de stabilisation radiale de l'élément magnétisable (10) qui est constitué des électro-aimants (11) entourant sans contact le noyau magnétisable, d'un appareil électronique de régulation (13) et de détecteur de position (14), les électro-aimants recevant de l'appareil électronique de régulation des signaux qui sont produits par celui-ci en fonction des signaux de détecteur de position, lesquels correspondent aux écarts du noyau magnétisable par rapport à sa position de consigne et, pour le déplacement radial du noyau magnétisable et/ou pour produire desmouvements oscillants périodiques du noyau magnétisable et/ou de mouvements de rotation de celui-ci, à alimenter les électro-aimants du dispositif de stabilisation radiale en courant alternatif ou triphasé, statique ou se modifiant périodiquement.

2. Procédé selon la revendication 1, caractérisé en ce qu'il consiste, pour obtenir l'allure déterminée à l'avance du mouvement du noyau magnétisable, à produire les courants alternatifs ou triphasés, statiques et/ou se modifiant périodiquement, en envoyant à l'appareil ou aux appareils de régulation (13) des signaux de guidage, qui correspondent à la position de consigne souhaitée, statique ou se modifiant dans le temps, (ou à l'allure du mouvement souhaité) du noyau (10) magnétisable.

3. Procédé suivant la revendication 2, caractérisé en ce qu'il consiste à envoyer aux appareils de régulation (13) des signaux de guidage de même fréquence, qui se distinguent d'un appareil de régulation à l'autre par leur amplitude et/ou par leur phase.

4. Procédé suivant la revendication 2, caractérisé en ce qu'il consiste à envoyer aux appareils de régulation (13) des signaux de guidage se modifiant dans le temps.

## Claims

1. Process for making a crystalline article from a melt, in which the melt (or crucible or supply ingot) and crystalline article perform such a movement relative to one another that, at the crystalline article drawn from the melt, two-dimensional intermixing of the melt is effected, characterized in that an apparatus for non-crucible zone melting and/or for drawing from a crucible and having a holder for ingot and crucible is used, to which holder for ingot and crucible a magnetizable core, suspended by means of a magnet (axial stabilizing magnet), is attached, a device for the axial displacement acting on the magnet, and in which at least one radial stabilizing device for the magnetizable core (10) is provided, which radial stabilizing device consists of electromagnets (11), surrounding the magnetizable core without contact, an electronic control unit (13) and position sensors (14), the electromagnets being acted upon by signals from the electronic control unit which are produced by the latter as a function of the signals from the position sensors, which respond to deviations of the magnetizable core from its desired position, and in that, to radially displace the magnetizable core and/or to produce periodic oscillatory movements of the magnetizable core and/or rotary movements of the same, static and/or periodically changing alternating or three-phase currents are fed into the electromagnets of the radial stabilizing device.

2. Process according to Claim 1, characterized in that, to produce the predetermined sequence of movement of the magnetizable core, the static and/or periodically changing alternating or three-phase currents are produced by command signals being fed into the control unit or control units (13) which command signals correspond to the desired, static position or desired position varied with time (or to the desired sequence of movement) of the magnetizable core (10).

3. Process according to Claim 2, characterized in that command signals of the same frequency are fed to the control units (13), which command signals differ in their amplitude and/or phase from control unit to control unit.

4. Process according to Claim 2, characterized in that command signals varying with time are fed to the control units (13).

FIG. 1

FIG. 1a

FIG.1b

FIG. 2

FIG.3

FIG. 4

FIG.5